Europäisches Patentamt

European Patent Office

Office européen des brevets

(19)

(11) Veröffentlichungsnummer: **0 002 829**
**B1**

(12) **EUROPÄISCHE PATENTSCHRIFT**

(45) Veröffentlichungstag der Patentschrift: **13.10.82**

(51) Int. Cl.³: **F 03 G 7/04, F 22 B 1/00**

(21) Anmeldenummer: **78101850.2**

(22) Anmeldetag: **27.12.78**

(54) **Vorrichtung zur energetischen Verwertung der in tiefen Gewässern, insbesondere im Meer herrschenden Temperaturverhältnisse.**

(30) Priorität: **28.12.77 AT 9376/77**
**16.10.78 AT 7430/78**

(43) Veröffentlichungstag der Anmeldung:
**11.07.79 Patentblatt 79/14**

(45) Bekanntmachung des Hinweises auf die Patenterteilung:
**13.10.82 Patentblatt 82/41**

(84) Benannte Vertragsstaaten:
**BE CH DE FR GB IT LU NL SE**

(56) Entgegenhaltungen:
DE - C - 457 085
FR - A - 777 778
FR - A - 814 146
US - A - 1 952 520
US - A - 3 896 622
US - A - 4 030 301
US - A - 4 100 744
ASTRONAUTICS AND AERONAUTICS, Vol. 13,
Nr. 11, November 1975, New York, USA, G. L.
DUGGER "Ocean thermal energy conversion",
Seiten 58—63

(73) Patentinhaber: **Egerer, Paul K.**
**Schlüsselgasse 9**
**A-1040 Wien (AT)**

(72) Erfinder: **Egerer, Paul K.**
**Schlüsselgasse 9**
**A-1040 Wien (AT)**

(74) Vertreter: **Binder, Otto, Dipl.-Ing.**
**Stallburggasse 2**
**A-1010 Wien (AT)**

(56) Entgegenhaltungen:
TRANSACTIONS ASME, Serie B, Journal of
engineering for Industry, Vol. 96, Nr. 4,
November 1974, New York, USA, J. G.
McGOWAN "Ocean thermal difference powerplant design", Seiten 1119—1129

**0 002 829**

Vorrichtung zur energetischen Verwertung der in tiefen Gewässern,
insbesondere im Meer herrschenden Temperaturverhältnisse

Die Erfindung bezieht sich auf eine Vorrichtung zur energetischen Verwertung der in tiefen Gewässern, insbesondere im Meer herrschenden Temperaturverhältnisse, umfassend zwei durch eine Leitung miteinander verbundene Behälter, von denen einer innerhalb des Gewässers und der andere außerhalb des Gewässers in einem Bereich niedrigerer Temperatur als der im Gewässer definfliche Behälter angeordnet ist, und zwischen denen ein infolge der Temperaturdifferenz zwischen den beiden Behältern vom flüssigen in den gasförmigen Zustand übergehendes Medium strömt, und mit einer zwischen den beiden Behältern angeordneten Energieumwandlungseinrichtung, insbesondere Turbine, mit welcher die Energie des aus dem innerhalb des Gewässers befindlichen zu dem außerhalb des Gewässers befindlichen Behälter strömenden Mediums ausgenützt wird, wobei nach der Turbine ein Kondensator angeordnet ist.

Bekanntlich besteht ein dringlicher Bedarf an entwicklungsfähigen Methoden zu einer umweltfreundlichen Energiegewinnung, die eine Verwertung vorhandener Naturkräfte zulassen, ohne hierfür Grundstoffe, insbesondere Brennstoffe, zu verbrauchen, welche naturgemäß nur in beschränktem Umfang verfügbar sind und deren Vergeudung weder wirtschaftlich noch hinsichtlich der damit einhergehenden Umweltverschmutzung und Umweltveränderung auf Dauer vertretbar ist.

Es ist bereits bekannt (FR—A—814 146), Energie unter Ausnutzung eines Temperaturgefälles ohne den Einsatz von Brennstoffen zu gewinnen, um damit eine Turbine zur Stromerzeugung anzutreiben. Dabei werden zwei Behälter verwendet, von denen einer innerhalb eines Gewässers und der andere oberhalb des Gewässers angeordnet ist. Ein sich durch Temperatureinwirkung vom flüssigen in den gasförmigen Zustand änderndes Medium strömt durch eine Verbindungsleitung zwischen beiden Behältern, wodurch eine Turbine zur Energieumwandlung angetrieben wird. Im anderen Behälter verflüssigt sich das gasförmige Medium, so daß es aufgrund der Schwerkraftstromung oder von Pumparbeit zum ursprünglichen Ausgangsbehälter zurückgeführt werden kann. Eine solchermaßen stationäre Vorrichtung eignet sich noch nicht in zufriedenstellender Weise für eine wirtschaftliche Energieausnutzung, weil dort zur Erzielung eines brauchbaren Temperaturgefälles mitunter sehr große Distanzen zwischen den beiden Behältern gegeben sind. Insbesondere bedarf es zur Rückführung des Kondensats in den Ausgangsbehälter einer zusätzlichen Verbindungsleitung, was einen vorrichtungsmäßigen Aufwand bedeutet.

Weiter ist eine das Temperaturgefälle in einem Gewässer ausnutzende Vorrichtung bekannt (US—A—3 896 622), bei welcher ein in einem Behälter befindliches Medium in einem Gewässerbereich höherer Temperatur expandiert und dadurch einen im Behälter befindlichen Kolben anhebt. Schließlich wird der Behälter mittels einer Seilwinde in einen Gewässerbereich tieferer Temperatur abgesenkt, wo das Medium kondensiert. Nach dem Lösen einer Klemmvorrichtung kann dann der Kolben seinen Arbeitshub ausführen, wonach der Behälter mittels einer Seilwinde hochgezogen wird. Bei dieser Vorrichtung wird der Wirkungsgrad wesentlich durch die für die Bewegung des Behälters samt der darin angeordneten Kolbeneinrichtung erforderliche Energie geschmälert. Nachteilhaft ist weiter, daß jeder Zyklus zur Energiegewinnung ein Absenken und anschließendes Hochheben des Behälters erfordert, was einen zeitlichen Aufwand bedeutet.

Hier will die Erfindung Abhilfe schaffen. Die Erfindung, wie sie in den Ansprüchen gekennzeichnet ist, löst die Aufgabe, eine Vorrichtung der in der FR—A—814 146 beschriebenen Art derart weiterzubilden, daß mit einfachen Maßnahmen ein höherer Wirkungsgrad bei der Energiegewinnung ermöglicht ist.

Durch die Erfindung werden die beiden für die Expansion sowie für die Verflüssigung des zur Energiegewinnung herangezogenen Mediums erforderlichen Behälter wechselweise abgesenkt. Das heißt, der auf der Gewässeroberfläche schwimmende zuvor als Sammelbehälter dienende Behälter wird nach Füllung mit dem Kondensat, also nach entsprechender Entleerung des sich innerhalb des Gewässers befindenden Behälters, in das Gewässer abgesenkt, während der geleerte Behälter zur Gewässeroberfläche hochsteigt. Der abgesenkte Behälter dient dann als Ausgangsbehälter, wobei das Medium nunmehr in umgekehrter Richtung die Verbindungsleitung zwischen den beiden Behältern durchströmt. Für die Überleitung des Kondensats zum anderen Behälter bedarf es somit keinerlei gesonderter Verbindungsleitung, was den Einsatz dieser Vorrichtung auch bei größeren Distanzen ermöglicht, die erst das entsprechende Temperaturgefälle zur wirtschaftlichen Ausnutzung ergeben. Da das Medium ein gegenüber dem Wasser größeres spezifisches Gewicht besitzt, erfordert das Absenken des mit Kondensat gefüllten Behälters keinerlei Energie, so daß hiedurch der Wirkungsgrad nicht beeinträchtigt wird.

Als Medien, die in der Vorrichtung Verwendung finden, eignen sich insbesondere die im Anspruch 2 angegebenen Stoffe.

Die nach Maßgabe des Anspruchs 3 vorgesehenen Halteorgane gewährleisten zweckmäßigerweise, daß der sich innerhalb des Gewässers befindende Behälter erst nach vollständiger Entleerung hochsteigen kann, wenn nämlich die Halteorgane gelöst werden.

Der nach Maßgabe des Anspruchs 4 vorgesehene Wärmeaustauscher eignet sich insbesondere in Zusammenhang mit der Verwendung einer Turbine als Energieumwandlungseinrichtung, weil dort das

**0 002 829**

Medium auf die für den Turbinenbetrieb geeignete Temperatur gebracht werden kann, so daß der Betrieb der Turbine oberhalb des Naßdampfbereiches gewährleistet werden kann.

Zweckmäßigerweise ist die Größe der Volumina der Behälter und/oder deren Füllungsgrad änderbar, vorzugsweise regelbar, so daß die jeweils erforderlichen günstigen Druckverhältnisse im Behälter eingestellt werden können. Die Kapazität des Behälters kann hierbei biespielsweise nach oben hin dadurch begrenzt werden, indem der Behälter als Taltenbalg ausgestaltet oder teleskopförmig ausgebildet wird.

Zweckmäßigerweise ist schließlich die Isolierwirkung der Behälterwandungen änderbar, vorzugsweise regelbar. Damit kann in optimaler Weise den Bedingungen Rechnung getragen werden, die es erfordern, daß einerseits während des Absenkens des Behälters ein Verdampfen des Mediums verhindert, andererseits aber im abgesenkten Zustand ein guter Wärmeübergang gewährleistet wird. Eine solche Isolierung läßt sich auf verschiedenerlie Weise erzielen, beispielsweise durch Verwendung eines Behältermantels, dessen Füllung variabel ist, oder der den Behälter nur phasenweise einschließt, beispielsweise im Weg des Behältes bereichsweise einen Schacht bildet, in dem der Behälter abgesenkt oder gehoben wird, oder eine Glocke, die mit dem Behälter gemeinsam absinkt und ihn nur in der Tiefstlage freigibt. Nach dem Absenken des Behälters soll zweckmäßigerweise für einen möglichst guten, d.h. möglichst raschen Wärmeübergang gesorgt werden.

Im Folgenden wird die Erfindung anhand der Zeichnungen näher erläutert. Darin zeigen

Fig. 1 eine schematische Darstellung einer Ausführungsform zur Erläuterung der Betriebsweise der Vorrichtung, sowie

Fig. 2 bis 4 Zustandsdiagramme.

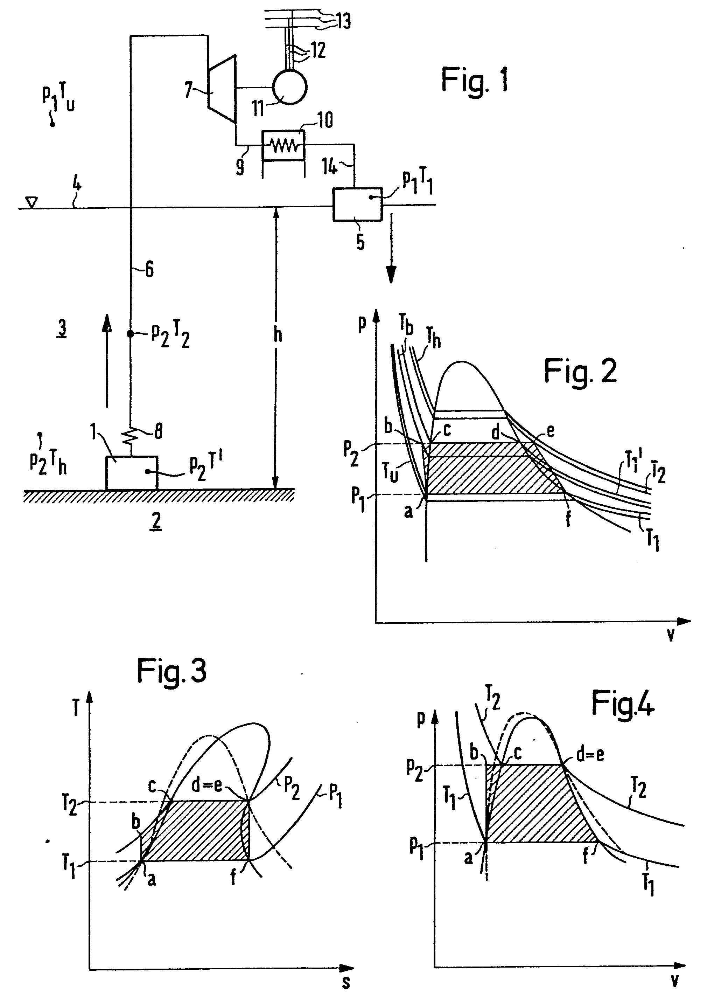

Im Einzelnen zeigt die Fig. 2 graphisch den Ablauf der physikalischen Änderungen im Verlauf des Verfahrens, die Fig. 3 ist ein Temperatur-Entropie-Diagramm und die Fig. 3 und 4 zeigen im Vergleich verschiedene Grenzkurven.

Gemäß der Darstellung der Fig. 1 befindet sich sich ein mit 1 bezeichneter Behälter in einer Tiefstellung auf dem Boden 2 des Gewässers 3, dessen freie Oberfläche mit 4 bezeichnet ist.

Der zweite, im Bereich der freien Oberfläche 4 des Gewässers 3 befindliche Behälter 5 ist über die Verbindungsleitung 6 mit dem unten befindlichen Behälter 1 verbunden, welche zu der als Energieumwandler benutzten Turbine 7 führt; in dieser Verbindungsleitung 6 ist im Bereich des Behälters 1 ein als Überhitzer dienender Wärmeaustauscher 8 angeordnet.

Eine Verbindungsleitung 9 verbindet die Turbine 7 mit einem Kondensator 10. Diese Turbine 7 ist ferner einem Generator 11 zugeordnet, von dem Stromleitungen 12 in ein Stromversorgungsnetz 13 führen. Das zum Behälter 5 strömende Medium gelangt über die Verbindungsleitung 14 dorthin.

Im oberen Behälter 5 herrschte der Druck $P_1$ und die Temperatur $T_1$, im unteren Behälter (unmittelbar vor dem Aufsteigen, also im Betriebszustand) der Druck $P_2$ und die Temperatur $T'$. Der atmosphärische Druck beträgt gleichfalls im wesentlichen $P_1$, die Außentemperatur außerhalb des Gewässers 3 beträgt $T_u$, hingegen beträgt der Druck in der Wassertiefe h gleichfalls im wesentlichen $P_2$, und die Temperatur beträgt dort $T_h$. In der Verbindungsleitung 6 beträgt der Druck $P_2$, die Temperatur $T_2$.

Die Fig. 2 bis 4 stellen Zustandsdiagramme dar. Die schraffierten Flächen geben die Arbeit während eines Zyklus bezogen auf 1 kg Masse (bzw. Leistung bezogen auf 1 kg/s) an. Die Arbeit im Zyklus ergibt sich auch als Differenz der zu- und abgeführten Wärmen.

Im einzelnen zeigt die Fig. 2 den Kreisprozeß für das erfindungsgemäße Verfahren. Das p-v-Diagramm enthält neben den Grenzkurven und den Zustandsänderungen während des Kreisprozesses auch noch die wichtigsten Isothermen:

Unmittelbar nach dem Absenken (noch ohne Wärmeaustausch) hat das Medium die Temperatur $T_b$ (Fig. 2). Im Behälter 1 bildet sich nun infolge der Wärmezufuhr durch das Umgebungswasser Sattdampf, der anschließend im Überhitzer, dem Wärmeaustauscher 8, auf die Temperatur $T_2$ gebracht wird. Diese Temperatur $T_2$ soll so hoch sein, daß die Expansion in der Turbine 7 unterhalb des Naßdampfbereiches bleibt. Der Behälter 1 enthält im Betriebszustand siedendes Medium und gesättigten Dampf.

Unterhalb der Grenzkurve befindet sich das Zweiphasengebiet (Naßdampfgebiet). Es ergeben sich folgende Zustände:

a   Zustand hinter dem Kondensator 10 und im Behälter 5
b   Zustand unmittelbar nach dem Absenken des Behälters 1 (noch ohne Wärmeaustausch mit dessen Umgebung)
c   Zustand der Flüssigkeit im Behälter 1 im Betrieb
d   Zustand des Dampfes im Behälter 1 im Betrieb
e   Zustand des Dampfes nach dem Überhitzen im Überhitzer (Wärmeaustauscher 8) bis zum Eintritt in die Turbine 7
f   Zustand hinter der Turbine 7 bis zum Eintritt in den Kondensator 10.

Die Fig. 3 stellt eine überhängende Grenzkurve im Temperatur-Entropie-Diagramm dar. Die Grenzkurve üblicher Stoffe wurde zum Vergleich gestrichelt eingezeichnet.

3

Die Fig. 4 zeigt den Vergleich der beiden Grenzkurven aus Fig. 3 im p-v-Diagramm.

Aus Fig. 2 sind demnach die Änderungen der physikalischen Werte des Mediums während des thermodynamischen Prozesses ersichtlich, wobei die Abszisse mit dem Wert v das spezifische Volumen, die Ordinate den Druck p ablesen läßt. Es bedeuten in diesem die Grenzkurve darstellenden Diagramme die Bereiche

| a—b | das Absenken des Behälters 1, das möglichst ohne Wärmeaustausch erfolgen soll, wobei also der Behälter möglichst gut zu isolieren ist; |
| b—c | das Erwärmen des Mediums auf Siedetemperatur T' in der Tiefstlage des Behälters 1 durch Umgebungswasser; |
| c—d | das Verdampfen des Mediums; |
| d—e | das Überhitzen des Sattdampfes auf die Temperatur $T_2$ im Wärmeaustauscher 8; |
| e—f | die Energieumwandlung infolge Ausnützung des Druckgefälles in der Turbine 7; |
| f—a | die Kondensation des Mediums im Kondensator 10. |

Der schraffierte Teil des Diagrammes ist die Arbeitsfläche, sie ist ein Maß für die zu erwartende Leistung des Verfahrens.

Begreiflicherweise ist der Temperaturbereich, in welchen gearbeitet wird, durch die Umgebungstemperatur $T_u$ der Atmosphäre, mit welcher der Kondensator 10 gekühlt wird, und durch die Temperatur $T_h$ in der Wassertiefe h festgelegt.

Der Druck $P_2$ in der Wassertiefe h soll so groß sein, daß die Expansion des überhitzten Dampfes mit der Temperatur $T_2$ nicht in das Naßdampfgebiet zu liegen kommt. Um den Wärmeübergang zu gewährleisten, muß $T_2 < T_h$ und $T_1 > T_u$ sein. Für die erforderlichen Temperaturdifferenzen mögen etwa 3°C genügen.

Besonders günstig wird die Wirkungsweise und der Wirkungsgrad des erfindungsgemäßen Verfahrens, wenn das Arbeitsmedium eine "überhängende" Grenzkurve aufweist, wie sie etwa die Fig. 3 zeigt, die ein Zustands-Diagramm darstellt, in welchen in der Abszisse die spezifische Entropie s, in der Ordinate die Temperatur T ersichtlich sind. Die von der Grenzkurve eingeschlossene Fläche entspricht der Differenz zwischen der zugeführten und der abgeführten Wärme. Bei einem solchen Medium tritt bei der Expansion des Sattdampfes in der Turbine 7 keinerlei Kondensation auf und der Zustand nach der Expansion liegt—gemäß dem spezifischen Entropie-Diagramm der Fig. 3 bzw. dem Druck-Volumen-Diagramm nach Fig. 4—wieder auf der Grenzkurve.

Wie schon erwähnt, soll die Dichte des Kondensates möglichst hoch in bezug zu jener des Wassers sein, d.h. der Behälter mit dem Kondensat soll jeweils einwandfrei und rasch absinken. Es eignen sich demnach hauptsächlich folgende Stoffe als Medien zur Durchführung des Verfahrens:

|  | | Druck [bar] | | Dichte der siedenden Flüssigkeit bei 0°C [kg/m³] |
| Siedetemperatur in °C | | | | |
|  | 1 | 2 | 5 | |
| Chlor | | −17,2 | 10,0 | 1,469 |
| Jodwasserstoff | | −18,4 | 7,1 | 2,369 |
| Difluorchlormethan | | −25 | 0,1 | 1,285 |
| Schwefeldioxyd | −10,3 | +6,1 | 31,8 | 1,435 |
| Stickstofftetroxyd | | −4,7 | 21,2 | 1,490 |
| Methylchlorid | | −6,7 | 21,7 | 1,362 |
| Difluordichlormethan | | −12,5 | 15,7 | 1,394 |
| Trifluorchloräthylen | | −11,5 | 15,2 | 1,370 |
| Oktofluorcyclobutan | | −7,0 | 39,0 | 1,616 |

Das letzterwähnte Medium weist vorteilhafterweise die überhängende Grenzkurve nach Fig. 3 auf. Der Zustand hinter der Turbine 7 liegt jedoch im Gebiet des überhitzten Dampfes und nicht wie in Fig. 3 bzw. 4 auf der Grenzkurve. Dadurch kann die Temperaturdifferenz nicht so gut ausgenützt werden.

Als Zahlenbeispiele seien angeführt:

Der maximale Wirkungsgrad für einen Kreisprozeß, der zwischen den Temperaturen 1 10°C und +5°C durchgeführt wird, beträgt $\eta_{max} = 5,4$ o/oo.

Wenn 3 grd Temperaturdifferenz für den Wärmeübergang berücksichtigt werden, so erhält man $\eta_{max} = 3,27$ o/oo. Diese kleinen Werte für den Wirkungsgrad schließen jedoch eine wirtschaftliche Nutzung des erfingungsgemäßen Verfahrens keineswegs aus, weil sich mit geringen Kosten Anlagen für große Energiemengen errichten lassen.

0 002 829

Spezifische Leistung mit

| | überhitztem Dampf | | Sattdampf | | |
| --- | --- | --- | --- | --- | --- |
| | $\frac{kW}{kg/s}$ | $\Delta p$ [bar] | $\frac{kW}{kg/s}$ | $\Delta p$ [bar] | $P_1$ [bar] |
| Schwefeldioxyd | 8,37 | 0,39 | 20,93 | 0,9 | 1,0 |
| Difluorchlormethan | 16,74 | 1,16 | 23,02 | 2,32 | 3,6 |
| Difluordichlormethan | 7,66 | 1,32 | 8,71 | 1,60 | 2,1 |
| Octafluorcyclobutan | — | — | 4,81 | 0,63 | 1,0 |

In dieser Tabelle bedeuten $\Delta p$ die Druckdifferenz und $p_1$ den Druck im Kondensator 10. Bei —10°C würden sich 0,9 bar ergeben, 1,0 bar ergibt sich bei —7°C.

Mit herkömmlichen Stoffen kann man bei Temperaturen von —10°C und +5°C bestenfalls mit einer Druckdifferenz von 2,5 bar rechnen. Wenn berücksichtigt wird, daß die Turbine 7 nicht im Naßdampfbereich arbeiten soll, wobei sich deren Leistung infolge Kondensierender Tröpfchen verringern würde, kann man im günstigsten Fall mit 1,5 bar rechnen.

Selbstverständlich ist die Erfindung in ihren Details mannigfach abwandelbar und ausbaufähig ohne vom Grundgedanken abzuweichen. Insbesondere hinsichtlich der Ausbildung der beiden im Wechsel ab- und auftauchenden Behälter 1 und 5 bestehen vielerlei Möhlichkeiten, die zu einer Verbesserung der angestrebten Wirkungsweise des Verfahrens vorteilhaft beitragen.

In der schematischen Darstellung der Fig. 1 ist der Übersichtlichkeit und der Einfachheit halber nur der dem Behälter 1 zugeordnete Wärmeaustauscher 8 und Kondensator 10 eingezeichnet, also nur jene Bestandteile der Einrichtung, welche beim Auftauchen des Behälters 1 wirksam werden. Selbstverständlich müssen die gleichen Bestandteile aber auch dem Behälter 5 zugeordnet werden, welcher im ständigen Wechsel mit dem Behälter 1 auf- und abwärts bewegt wird.

## Patentansprüche

1. Vorrichtung zur energetischen Verwertung der in tiefen Gewässern, insbesondere im Meer herrschenden Temperaturverhältnisse, umfassend zwei durch eine Leitung (6, 14) miteinander verbundene Behälter (1, 5), von denen einer (1) innerhalb des Gewässers und der andere (5) außerhalb des Gewässers in einem Bereich niedrigerer Temperatur als der im Gewässer befindliche Behälter angeordnet ist, und zwischen denen ein infolge der Temperaturdifferenz zwischen den beiden Behältern (1, 5) vom flüssigen in den gasförmigen Zustand übergehendes Medium strömt, und mit einer Zwischen den beiden Behältern angeordneten Energieumwandlungseinrichtung, insbesondere Turbine (7), mit welcher die Energie des aus dem innerhalb des Gewässers befindlichen zu dem außerhalb des Gewässers befindlichen Behälter (5) strömenden Mediums ausgenützt wird, wobei nach der Turbine (7) ein Kondensator (10) angeordnet ist, dadurch gekennzeichnet, daß beide Behälter (1, 5) schwimmfähig ausgebildet und wechselweise in das Gewässer absenkbar sind, wobei die Absenkung des auf der Gewässeroberfläche (4) befindlichen Behalters (5) erfolgt, nachdem das ein größeres spezifisches Gewicht als Wasser aufweisende Medium aus dem innerhalb des Gewässers befindlichen Behälter (1) nach Energieausnutzung in den auf der Gewässeroberfläche befindlichen Behälter überströmt ist, und wobei der innerhalb des Gewässers befindliche Behälter (1) nach seiner Entleerung hochsteight und das Medium dann die Verbindungsleitung (6, 14) in umgekehrter Richtung durch strömt.

2. Vorrichtung nach Anspruch 1, dadurch gekennzeichnet, daß als Medium Chlor, Jodwasserstoff, Difluormethan, Schwefeldioxyd, Stickstofftetroxyd, Methylchlorid, Difluormethan, Trifluoräthylen, Okatfluorcyclobutan verwendbar ist.

3. Vorrichtung nach Anspruch 2, dadurch gekennzeichnet, daß der innerhalb des Gewässers befindliche Behälter (1) bis zum Abschluß der energetisch verwertbaren Aufwärtsströmung des Mediums in seiner Solltiefe mittels ferngesteuerter Halteorgane festgehalten ist.

4. Vorrichtung nach einem der vorhergehenden Ansprüche, dadurch gekennzeichnet, daß in der Verbindungsleitung (6, 14) im Bereich jedes Behälters (1, 5) ein Wärmeaustauscher (Überhitzer) (8) angeordnet ist.

5. Vorrichtung nach einem der vorhergehenden Ansprüche, dadurch gekennzeichnet, daß die Größe der Volumina der Behälter (1, 5) und/oder deren Füllungsgrad änderbar, vorzugsweise regelbar ist.

6. Vorrichtung nach einem der vorhergehenden Ansprüche, dadurch gekennzeichnet, daß die Isolierwirkung der Behälterwandungen änderbar, vorzugsweise regelbar ist.

## Revendications

1. Dispositif pour transformer en énergie les différences de température existant dans des eaux profondes, particuliérement dans la mer, comprenant deux réservoires (1,5) reliés entre-eux par un conduit (6, 14), l'un des réservoires (1) est disposé dans les eaux et l'autre (5) endehors des eaux, dans une région de témperature plus basse que celle du réservoir se trouvant dans les eaux, et entre lesquels

5

coule un médium qui passe de l'état liquide à l'état gazeux par suite réservoirs (1,5) et avec une installation de transformation de l'énergie entre les deux réservoirs, spécifiquement une turbine (7), avec laquelle l'énergie du médium qui coule du réservoir (5) se trouvant en-dehors des eaux est utilisée, où est disposé après la turbine (7) un condensateur (10), caractérisé par le fait, que les deux réservoirs (1,5) sont construits de façon à ce qu'ils peuvent flotter et peuvent etre l'un ou l'autre immergé dans les eaux, et où l'immersion du réservoir (5) qui se trouve à la surface des eaux (4) peut s'effectuer après ce quele médium qui a un poids spécifique plus grand que l'eau coule du réservoir (1) qui se trouve dans les eaux, après avoir utilisé l'énergie vers le réservoir (1) qui se trouve sous les eaux remonte après son vidage et le médium coule dans le conduit de raccordement (6, 14) dans le sens inverse.

2. Un dispositif suivant la revendication 1, caractérisé par le fait, que l'on peut utiliser comme médium du chlore, de l'hydrogène iodique, du difluométhane, de l'anhydride sulfureux, du tétroxyde azotique, du chlorure méthylique, du trifluorméthane, du trifluor d'éthylène, du octafluorbutane.

3. Une dispositif suivant la revendication 2, caractérisé par le fait, que le réservoir (1) qui se trouve dans les eaux est retenu dans sa profondeur exigée justu'à la fin du coulement vers le haut de l'énergie utilisable du médium par des moyens de retenue commandés à distance.

4. Un dispositif suivant une des revendications précédents, charactérisé par le fait, que dans le conduit de raccordement (6, 14) est disposé dan le domaine de chaque réservoir (1, 15) une échangeur de température (une surchauffeuer) (8).

5. Un dispositif suivant une des revendications précédents, charactérisé par le fait, que le grandeur des volumes de réservoirs (1, 5) et/ou leur degré de remplissage est variable, de préférence réglable.

6. Un dispositif suivant une des revendications précédents, characterisé par le fait, que l'effet de l'isolement des parois des réservoirs est variable, de préférence réglable.

## Claims

1. Means for the conversion into energy of the varying conditions of temperature existant in deep waters, particularly the sea, including two tanks (1, 5), which are connected together by a line (6, 14); one of the tanks (1) is situated within the waters and the other (5) is located outside the waters in a surrounding of lower temperature than the one which is located in the waters; between these two tanks (1, 5) and owing to the difference of temperature in these two tanks (1, 5) there flows a medium changing from the liquid state into the gaseous state and between the two tanks there is a power conversion installation, especially a turbine (7) through which the energy of the medium is flowing from the tank located within the waters to the tank (5) located outside the waters is utilized, whereby after the turbine (7) a condenser (10) is arranged, characterized by the fact, that both tanks (1, 5) were built in a way, that they can swim and can alternately be immersed in the waters, whereby the immersion of the tank (5), which is located on the surface (4) of the waters is taking place after that the medium, which has a greater specific weight than water, has flowed from the tank (1), which is located underneath the waters after utilization of the energy into the tank which is located on the surface of the waters and whereby the tank (1), which is located underneath the waters rises after its being emptied and the medium is flowing in the connecting line (6, 14) in the reverse direction.

2. Means according to Claim 1, characterized by the fact, that the following medium can be used: chlorine, iodine hydrogen, sulphurous anhydride, nitrogen tetroxide, methyl chloride, difluorine methane, trifluorine ethylene, octafluorine cyclobutane.

3. Means according to Claim 2, characterized by the fact, that the tank (1), which is located within the waters is retained in the required depth up to the end of utilizable upflow of the medium by the means of remotely controlled holding devices.

4. Means according to one of the above mentioned claims, characterized by the fact, that on the connecting line (6, 14) within the reach of every tank (1, 5) a heat exchanger (8) is arranged.

5. Means according to one of the above mentioned claims, characterized by the fact, that the dimensions of the volumes of the tanks (1, 5) and/or their degree of filling are variable, especially controllable.

6. Means according to one of the above mentioned claims characterized by the fact, that the effect of the isolation of the walls of the tanks is variable, especially controllable.

Fig. 1

Fig. 2

Fig. 3

Fig. 4